# EUROPEAN PATENT SPECIFICATION

(11) **EP 2 257 658 B1**
(45) Date of publication and mention of the grant of the patent: **26.08.2015**
(21) Application number: 09714552.8
(22) Date of filing: 18.02.2009
(51) Int. Cl.: C30B 29/04, C30B 25/18, C23C 16/02, C23C 16/27, C30B 25/10

(54) **METHOD OF MAKING NUCLEATION LAYER FOR DIAMOND GROWTH**
VERFAHREN ZUR HERSTELLUNG EINER KEIMBILDUNGSSCHICHT FÜR DIAMANTZÜCHTUNG
PROCÉDÉ DE RÉALISATION D UNE COUCHE DE NUCLÉATION POUR LA CROISSANCE D UN DIAMANT

(30) Priority: 25.02.2008 CZ 20080104
(43) Date of publication of application: 08.12.2010
(73) Proprietor: Institute of Physics of the AS CR, v.v.i., 182 21 Praha 8 (CZ)
(72) Inventor: REZEK, Bohuslav, 182 00 Praha 8 (CZ); VANECEK, Milan, 143 00 Praha 4 - Komorany (CZ); KROMKA, Alexander, 951 36 Lehota (SK); POTOCKY, Stepan, 417 05 Osek (CZ); POTMESIL, Jiri, 250 82 Uvaly (CZ)
(74) Representative: Beetz & Partner mbB
(86) International application number: PCT/CZ2009/000018
(87) International publication number: WO 2009/106023

(56) References cited:
- WO-A-95/31592
- US-A- 5 474 808
- US-A- 5 897 924
- US-A1- 2007 232 074
- WANG ET AL: "Precise patterning of diamond films for MEMS application" J.MATERIALS PROCESSING TECHNOLOGY, vol. 127, 2002, pages 230-233, XP002527670
- KATSUMATA S ET AL: "Patterning of CVD diamond films by seeding and their field emission properties" DIAMOND AND RELATED MATERIALS, ELSEVIER SCIENCE PUBLISHERS, AMSTERDAM, NL, vol. 3, no. 11-12, 1 November 1994 (1994-11-01), pages 1296-1300, XP024178767 ISSN: 0925-9635 [retrieved on 1994-11-01]
- WANG X ET AL: "Synthesis of diamond from polymer seeded with nanometer-sized diamond particles" JOURNAL OF CRYSTAL GROWTH, ELSEVIER, AMSTERDAM, NL, vol. 181, no. 3, 1 November 1997 (1997-11-01), pages 308-313, XP004095417 ISSN: 0022-0248
- MAKITA H ET AL: "Ultrahigh particle density seeding with nanocrystal diamond particles" THIN SOLID FILMS, ELSEVIER-SEQUOIA S.A. LAUSANNE, CH, vol. 281-28, no. 1, 1 August 1996 (1996-08-01), pages 279-281, XP004012807 ISSN: 0040-6090

## Description

### Technical field

The invention relates to the fabrication of a nucleation layer for the growth of synthetic diamond on various types of substrates.

### Background art

High surface energy of diamond makes it difficult to grow polycrystalline and crystalline diamond layers with the thickness of tens of nanometers on non-diamond-based substrates. Surface modifications of the substrates are indispensable before starting the growth process. The surface modifications, often referred to as nucleation or seeding, are intended to allow for the growth of compact thin films of diamond with a minimal number of morphologic defect, such as holes in the layer, excessive variability of sizes of the diamond grains, excessive roughness of the surface, etc.

During the surface modification (the so-called nucleation process), parameters of this process (temperature, time, concentration of gasses and mixtures, electric bias, etc.) are monitored and the suitability of the substrate (only flat two-dimensional or complicated three-dimensional surfaces), its chemical composition and possible reactions with carbon (formation of carbide interlayers, catalytic dissolution of diamond, etc.) are determined. Parameters important for successful simulations of the growth on non-diamond-based substrates comprise particularly the density of structural defect, surface energy, the formation of carbide interlayers, resistance to bulk diffusion of carbon into the substrate, catalytic reaction of the substrate with the growing diamond layer and its mechanical properties (especially thermal expansion of the substrate with respect to diamond).

At the present time the basic modifications of non-diamond-based substrate are as follows:
a) the substrate surface being scratched with an abrasive,
b) the substrate surface being scratched with diamond or non-diamond powder,
c) the substrate being electrically biased and subsequently bombarded with ions or electrons,
d) deposition of carbon-based structures or materials (fullerenes, carbon fibers, clusters, polymers, carbon oil) on the substrate,
e) deposition of high-temperature metal (c-BN, SiC, WC, etc.) on the substrate,
f) implantation of largely carbon or metal ions into the substrate,
g) pulsed irradiation of the substrate surface with a laser,
h) chemical etching of the substrate surface,
i) carbonization of the substrate surface (saturation of the surface layer with carbon).

Apart from these techniques, a combination of the above-mentioned methods represents other possibilities of surface modifications.

The choice of the particular surface modification not only gives rise to different densities of nucleation centers, but also influences the quality of the growth of synthetic diamond, minimal thickness for obtaining a compact layer, resulting homogeneity, adhesion, the size of the grains, surface roughness, etc.

Generally speaking, the scratching of the surface is a cheap and simple technique. Its disadvantage, however, is the contamination of the substrate and its degradation (e.g. in optical properties). By and large, this method cannot be applied neither on complex three-dimensional nor on smooth, flat surfaces. A much less intrusive and simultaneously one of the most effective techniques is ion bombardment. During ion bombardment, the surface of the substrate is modified by the implantation of ions, which become the nucleation centers for the growth of synthetic diamond. Nevertheless, limitations put on the surface when this technique is used comprise the need for a planar surface with minimal surface roughness, which, in addition, needs to be electrically conductive, implying that such materials as ceramics and other insulators cannot be utilized in the process. An ultrasonic bath, on the other hand, limits the substrates to those which are not soft or thin.

The article "Precise patterning of diamond film for MEMS application" by X. D. Wang, published in 2002 in Journal of Materials Processing Technology, mentions selective growth of a diamond layer by means of photolitigraphy, where diamond powder with the grain sizes of 500 nm is mixed with a positive photoresist and then suspended in an ultrasound bath in order to achieve homogeneity. This mixture is then deposited on a silicon substrate, dried out and selectively exposed to UV irradiation. A layer prepared in this way is then exploited for the growth of a polycrystalline diamond layer, which can be grown by the microwave-plasma enhanced chemical vapor deposition.

The article "Patterning of CVD diamond films by seeding and their field emission properties" by S. Katsumata, published in Diamond and Related Materials in 1994, introduces a nucleation procedure in which diamond powder with differently sized grains (up to 250 nm) is mixed with a positive photoresist (OFPR). This mixture is then filtered (pore size 5 um) in order to get rid of clustered agglomerates. The filtered mixture is spin-coated on a substrate and selectively exposed to UV irradiation; this layer is then exploited for the growth of diamond by means of microwave-plasma enhanced chemical vapor deposition.

Another way to prepare a nucleation layer is put forward in Patent US 5474808 (Aslam, 1995). In this patent, diamond particles are mixed with a carrier, such as water or a photoresist, this mixture is then deposited onto a substrate and the substrate undergoes a chemical vapor deposition procedure, during which the polymer carrier is removed and the dispersed diamond particles transform into the diamond layer. Diamond particles and the photoresist are mixed mechanically, in an ultrasonic bath, afterwards, this mixture is deposited onto a silicon substrate and is dried at 80 °C for 20 minut.

Patent US 2007/0232074 A1 (Ravi et al., 2007) proposes a way to carry out nucleation for the growth of a diamond layer on a non-diamond substrate using a photoresist as a sacrificial layer by depositing at least two different average sizes of diamond particles. It is also possible to use a suspension of at least two average sizes of diamond particles in a positive or negative photoresist spin-coated on the substrate. The nucleated sample made by means of a sacrificial layer or the photoresist with diamond particles can then be utilized for the growth of diamond at temperatures between 700-900°C.

Patent US 5897924 (Ulczynski et al., 1999) suggests another way of nucleating substrates by polishing them with diamond particles with sizes 50-1000 nm or by the deposition of a mixture of these diamond particles with a photoresist, and subsequent growth of a diamond layer at 350-500°C by microwave-plasma enhanced chemical vapor.

### Disclosure of the invention

The present invention provides a method as set forth in claim 1 which both overcomes the above-mentioned limitations on the surface modifications and copes with the particularities of various substrates without compromising the quality of the grown diamond layer by utilizing a polar polymer composite containing diamond crystallites for the surface modification of the substrate. A highly advantageous and unique property of this method is its applicability on large areas (700 cm²) and consequently its simplicity and cheapness. The surface modification by nucleation from polar polymer composites allows for the growth of diamond layers also on soft substrates (e.g. made of synthetic polymer), on thin films of various materials (with thicknesses down to several nanometers), the growth of compact layers on large areas and the formation of various patterns.

The surface modification ensuring the quality of the grown diamond layer is based on the use of a suspension of nanocrystalline diamond (detonation diamond with grain sizes from 5 to 10 nm) with passivated surface and homogenously dispersed in carrier, which is a liquid synthetic polar polymer. The said suspension is deposited on flat substrates. The resulting thickness of the deposited polymer composite depends on the viscosity of the solution. The polymer composite is stabilized by higher temperature (hardened), giving rise to a compact, sufficiently mechanically stable and chemically stable layer on the substrate. The polymer composite is partially etched away. The first stage after the insertion of the substrate with the polymer composite into the reaction vessel for the growth of synthetic diamond consists in a partial burning out the remnants of the polymer e.g. in hydrogen plasma and the uncovered diamond grains then serve as nuclei for the growth of a compact diamond layer.

No special requirements, regarding the mechanical, optical or electric properties, are put on the substrates. Soft substrates (such as synthetic polymers), as well as hard substrates, both electrically conductive (metals, semiconductors) and insulating substrates (glass, ceramics, insulators) can be used. All the above-mentioned materials can be used even on large areas.

The thickness of the deposited polymer composite ranges from the order of nanometers to micrometers. Thin films are suitable especially for the growth of diamond on optically polished surfaces with roughness less than 1 nm. Thicker layers of polymer composite are suitable for the stimulation of the growth of diamond on surfaces with high surface roughness. In this case, the layer has a flattening effect on the surface.

Lithographic techniques (photolithography, electron beam lithography, scanning probe lithography, stamp lithography eventually in combination with lift-off techniques) allow for the deposition of the polymer composite on the predefined spots on the substrates. Such patterning gives rise to the selective growth on accurately geometrically defined areas.

The use of polymer composite is not limited solely to the fabrication of two-dimensional structures. It is also possible to produce combined three-dimensional structures defined on a layer-by-layer basis. Within the scope of this strategy, a combination of different types of materials in different layers in combination with the polymer composite can be deposited. This leads to the formation of a transition structure, which can be compared to a heterostructure known from the semiconductor industry.

The polymer composite can be deposited either only in one layer or repeatedly in several layers in order to both fully cover substrates with an uneven surface ranging from several nanometers to micrometers and eventually also flatten the surface irregularities by the grown synthetic diamond.

The said method of the fabrication of a nucleation layer for the growth of diamond films results in a homogenous dispersion of diamond particles in composite nucleation layer and thus, allowing a homogenous growth of diamond films regarding to their low thickness a low surface roughness. The nucleation layer can be exploited for the growth of ultra-thin diamond films intended for the fabrication of electronically active or passive elements, for the growth and formation of diamond nanostructures, for the growth of hetero-structures based on a combination of diamond with another material (usually a metal), for the fabrication of modified three-dimensional structures suitable for the filtration of both common and aggressive liquids, for a three-dimensional integration of diamond-metal structures intended for filtration with support of photochemical or electrochemical reactions, for the fabrication of modified three-dimensional passive or electrically active diamond-metal (or -semiconductor) structures stimulating the growth of cell cultures in biomedicine, for the fabrication of diamond templates for stamp lithography, etc.

### Example

An aqueous solution of the polymer is prepared by the dissolution of 25 mg of polyvinyl alcohol with the molecular weight of 80 000 g/mol in 1 ml of deionized water at the temperature of 60-70 °C during stirring. An aqueous solution containing 5 weight percent of diamond powder with the nominal size of particles of 5 nm dispersed in deionized water is ultrasonicated at room temperature for at least 10 minutes. 10 ml from the top part of this suspension are transferred to 120 ml of deionized water and the resulting suspension is sonicated again for at least 10 minutes. After ultrasonic cleaning, 25 ml of the suspension are added to the aqueous solution of polyvinyl alcohol. This solution of polyvinyl alcohol with diamond powder represents the polymer composite in liquid phase.

A boron-doped silicon substrate with the conductivity of 0.1 (Ωcm)⁻¹ and the thickness of 520 µm is ultrasonically cleaned in isopropanol for 5 minutes, then is dipped into deionized water and dried with a flow of dry air (or nitrogen). The solution of the polymer composite is deposited on the clean substrate. The substrate with the polymer composite is dried in air at the temperature of 120 °C for at least 40 minutes.

After the deposition of the nucleation layer of polymer composite on the silicon substrate the synthesis of diamond is carried out by microwave-plasma-enhanced chemical vapor deposition. 1 % dilution of methane in hydrogen, the pressure of 2000 Pa, flow rate of 5.05x10⁻⁶ m³/s, 600 W output of the plasma generator and the substrate temperature of 703 K are used during the deposition. The resulting layer has the thickness of about 370 nm.

The described method was used for the fabrication of diamond layers with thicknesses of 100 nm or more, at substrate temperatures ranging from 643 to 1153 K, on various types of substrates (glass, silicon, polymer). Moreover, step-like diamond layers with the step defined by optical lithography (step height of 3 µm and step spacing of 8-10 µm) were also fabricated.

### Industrial applicability

The described method of the fabrication of a nucleation layer with subsequent formation of diamond layers can be exploited in the manufacturing of thin film or bulk diamond structures intended for the fabrication of electronically active or passive elements, for the growth and formation of diamond nanostructures, for the growth of heterostructures based on a combination of diamond and another material (usually a metal), for the fabrication of modified three-dimensional structures suitable for the filtration of common or aggressive liquids, for the three-dimensional integration of diamond-metal structures intended for the filtration with support of photo- or electrochemical reactions, for the fabrication of modified three-dimensional passive of electrically active diamond-metal (or -semiconductor) structures, for the stimulation of the growth of cell cultures in bio-medicine, for the fabrication of templates for stamp lithography, etc.

## Claims

1. The method of making nucleation layer for diamond growth by chemical vapor deposition, wherein:
• diamond powder is added into a solution of a polymer;
• said suspension is homogenized;
• the resulting polymer composite is deposited onto a cleaned substrate and is annealed to the temperature corresponding to the hardening temperature of the said polymer by drying the substrate in air at the temperature of 120 °C for at least 40 minutes;
• and the polymer composite is partially etched away, **characterized in that**:
• said solution of a polymer is an aqueous solution of polyvinyl alcohol prepared by the dissolution of 25 mg of polyvinyl alcohol with the molecular weight of 80 000 g/mol in 1 ml of deionized water at the temperature of 60-70 °C during stirring;
• and that said diamond powder is nanocrystalline detonation diamond with passivated surface and with grain sizes from 5 to 10 nm.

2. The method for the fabrication of the nucleation layer according to claim 1; wherein the polymer composite is prepared by:
o dispersing an aqueous solution containing 5 weight percent of diamond powder dispersed in deionized water;
o subjecting the resulting dispersion to ultrasonic cleaning at room temperature for at least 10 minutes;
o transferring 10 ml from the top part of this suspension to 120 ml of deionized water;
o subjecting the resulting suspension to ultrasonic cleaning again for at
least 10 minutes; and
adding 25 ml of the suspension after ultrasonic cleaning the aqueous solution of polyvinyl alcohol.

3. The method for the fabrication of the nucleation layer according to claim 1 or 2, **characterized in that** the diamond powder is chemically, optically or electrically passivated with a monolayer of atoms.

4. The methods for the fabrication of the nucleation layer according to claims 2 or 3, **characterized in that** the polymer composite is deposited onto the substrate in more than one layer.

5. The methods for the fabrication of the nucleation layer according to claims 2 or 3 or 4, **characterized in that** the remnants of the polymer composite are burnt out in hydrogen plasma after the etching-away stage.

6. Method according to one of the preceding claims, **characterized in that** the resulting polymer composite is deposited on the substrate in a spatially structured form.

## Patentansprüche

1. Methode zur Herstellung einer Nukleationsschicht für die Zucht von Diamanten durch chemische Dampfphasenabscheidung, wobei:
Diamantstaub in eine Lösung eines Polymers gegeben wird;
diese Suspension homogenisiert wird;
das resultierende Polymer-Komposit auf einem gereinigten Substrat abgeschieden wird und auf eine Temperatur getempert wird, welche der Härtungstemperatur des besagten Polymers entspricht, indem das Substrat für mindestens 40 Minuten bei einer Temperatur von 120 °C an der Luft getrocknet wird;
und wobei das Polymer-Komposit teilweise weggeätzt wird,
**dadurch gekennzeichnet, dass**:
die besagte Lösung eines Polymers eine wässrige Lösung eines Polyvinylalkohols darstellt, welche durch das Lösen von 25 mg Polyvinylalkohol mit einem Molekulargewicht von 80 000g/mol in 1 ml deionisiertem Wasser bei einer Temperatur von 60 - 70 °C unter Rühren hergestellt wird;
und es sich bei besagtem Diamantstaub um nanokristallinen Detonationsdiamant mit passivierter Oberfläche und mit Korngrößen zwischen 5 und 10 nm handelt.

2. Die Methode zur Herstellung einer Nukleationsschicht nach Anspruch 1, wobei das Polymer-Komposit hergestellt wird, indem
eine wässrige Lösung dispersiert wird, welche 5 Gewichtsprozent Diamantstaub enthält, welcher in deionisiertem Wasser dispersiert wird;
die erhaltene Lösung bei Raumtemperatur für mindestens 10 Minuten einer Reinigung mittels Ultraschall unterzogen wird; 10 ml dieser Lösung aus dem oberen Bereich in 120 ml deionisiertes Wasser überführt werden;
die so erhaltene Lösung erneut für mindestens 10 Minuten einer Reinigung mittels Ultraschall unterzogen wird; und indem 25 ml der Lösung nach der Reinigung der wässrigen Polyvinylalkohollösung zugeführt werden.

3. Die Methode zur Herstellung einer Nukleationsschicht nach Anspruch 1 oder 2, **dadurch gekennzeichnet, dass** der Diamantstaub chemisch, optisch oder elektronisch mit einer atomaren Monolage passiviert wird.

4. Die Methoden zur Herstellung einer Nukleationsschicht nach Anspruch 2 oder 3, **dadurch gekennzeichnet, dass** das Polymer-Komposit in mehr als einer Lage auf dem Substrat abgeschieden wird.

5. Die Methoden zur Herstellung einer Nukleationsschicht nach Anspruch 2, 3 oder 4, **dadurch gekennzeichnet, dass** die Reste des Polymer-Komposits nach dem Schritt des Wegätzens in Wasserstoffplasma ausgebrannt werden.

6. Die Methode nach einem der vorausgehenden Ansprüche,
**dadurch gekennzeichnet, dass** das resultierende Polymer-Komposit auf dem Substrat in räumlich strukturierter Form abgeschieden wird.

## Revendications

1. Procédé de fabrication d'une couche de nucléation pour une croissance de diamant par dépôt chimique en phase vapeur, dans lequel :
• de la poudre de diamant est ajoutée dans une solution d'un polymère ;
• ladite suspension est homogénéisée ;
• le composite polymère résultant est déposé sur un substrat nettoyé et est recuit à la température correspondant à la température de durcissement dudit polymère par séchage du substrat à l'air à la température de 120°C pendant au moins 40 minutes ;
• et le composite polymère est partiellement éliminé par gravure, **caractérisé en ce que** :
• ladite solution d'un polymère est une solution aqueuse de poly(alcool vinylique) préparée par la dissolution de 25 mg de poly(alcool vinylique) avec le poids moléculaire de 80 000 g/mole dans 1 ml d'eau désionisée à la température de 60-70°C sous agitation ;
• et **en ce que** ladite poudre de diamant est un diamant de détonation nanocristallin avec une surface passivée et avec des tailles de grains de 5 à 10 nm.

2. Procédé de fabrication de la couche de nucléation selon la revendication 1, dans lequel le composite polymère est préparé par :
o dispersion d'une solution aqueuse contenant 5 pour cent en poids de poudre de diamant dispersée dans de l'eau désionisée ;
o soumission de la dispersion résultante à un nettoyage par ultrasons à la température ambiante pendant au moins 10 minutes ;
o transfert de 10 ml de la partie supérieure de cette suspension dans 120 ml d'eau désionisée ;
o soumission de la suspension résultante à un nouveau nettoyage par ultrasons pendant au moins 10 minutes ; et
ajout de 25 ml de la suspension après nettoyage par ultrasons à la solution aqueuse de poly(alcool vinylique).

3. Procédé de fabrication de la couche de nucléation selon la revendication 1 ou 2, **caractérisé en ce que** la poudre de diamant est chimiquement, optiquement ou électriquement passivée avec une monocouche d'atomes.

4. Procédés de fabrication de la couche de nucléation selon les revendications 2 ou 3, **caractérisés en ce que** le composite polymère est déposé sur le substrat en plus d'une couche.

5. Procédés de fabrication de la couche de nucléation selon les revendications 2 ou 3 ou 4, **caractérisés en ce que** les restes du composite polymère sont brûlés dans un plasma d'hydrogène après l'étape d'élimination par gravure.

6. Procédé selon l'une des revendications précédentes, **caractérisé en ce que** le composite polymère résultant est déposé sur le substrat sous une forme spatialement structurée.
